# EUROPEAN PATENT APPLICATION

(11) **EP 3 664 580 A1**
(43) Date of publication of application: **10.06.2020**
(21) Application number: 18841529.3
(22) Date of filing: 02.08.2018
(51) Int. Cl.: H05B 33/10, B32B 7/02, B32B 27/06, H01L 51/50, H05B 33/04

(54) **METHOD FOR MANUFACTURING ORGANIC DEVICE, AND ORGANIC DEVICE**

(30) Priority: 02.08.2017 JP 2017150139
(71) Applicant: Sumitomo Chemical Company Limited, Tokyo 104-8260 (JP)
(72) Inventor: FUJII Takashi, Niihama-shi Ehime 792-0015 (JP); MATSUMOTO Yasuo, Niihama-shi Ehime 792-0015 (JP); MORISHIMA Shinichi, Tsukuba-shi Ibaraki 300-3294 (JP)
(74) Representative: J A Kemp LLP
(86) International application number: PCT/JP2018/029110
(87) International publication number: WO 2019/027014

(57) **Abstract**

A method for manufacturing an organic device 1 includes: a forming step of forming a plurality of organic device units 10 in one direction at predetermined intervals; an affixing step of affixing a sealing member 11 extending in the one direction along the one direction such that a part of each of a first electrode layer 5 and a second electrode layer 9 in each of the organic device units 10 is exposed and the sealing member 11 straddles across the plurality of organic device units 10; and a cutting step of dividing the plurality of organic device units 10 to which the sealing member 11 is affixed, in which in the affixing step, the sealing member 11 including a sealing base material 19 containing a material having conductivity, and an adhesive portion 17 containing a pressure-sensitive adhesive is affixed to the organic device unit 10, and in the cutting step, the sealing member 11 is cut such that a cutting blade B is allowed to approach from the sealing member 11 side, and the adhesive portion 17 after being cut protrudes to the outside from the sealing base material 19.

## Description

### Technical Field

The present invention relates to a method for manufacturing an organic device, and an organic device.

### Background Art

For example, an organic device described in Patent Literature 1 is known as an organic device of the related art. The organic device described in Patent Literature 1 includes a anode layer including at least a first electrode, an organic compound layer including a light emitting layer, a cathode layer including a second electrode, and a sealing member, on a substrate. In the organic device described in Patent Literature 1, the sealing member includes at least one resin base material and at least one barrier layer.

### Citation List

### Patent Literature

Patent Literature 1: Japanese Unexamined Patent Application Publication No. 2007-73332

### Summary of Invention

### Technical Problem

A sealing base material containing a material having conductivity can be used as the barrier layer of the sealing member. In a configuration in which the sealing member contains the sealing base material, the following problems are capable of occurring in a case of manufacturing the organic device. In a case where the organic device is manufactured, the sealing member is affixed to a plurality of organic device units such that a part of the first electrode and the second electrode is exposed, and then, is cut, and is divided for each of the organic devices. When the sealing member is cut, a cutting blade is allowed to approach with respect to the sealing member. At this time, the sealing base material formed of a material having conductivity is dragged to the cutting blade, and thus, there is a concern that the sealing base material is in contact with the electrode layer (the anode layer and the cathode layer). In a case where the sealing base material is in contact with the electrode layer, the anode layer and the cathode layer are electrically connected to each other, and thus, there is a concern that a short circuit occurs. Accordingly, the organic device fails to function, and reliability of the organic device may decrease.

According to one aspect of the present invention, an object of the present invention is to provide a method for manufacturing an organic device, and an organic device, in which a decrease in the reliability can be suppressed.

### Solution to Problem

A method for manufacturing an organic device according to one aspect of the present invention, includes: a forming step of forming a plurality of organic device units in which at least a first electrode layer, an organic functional layer, and a second electrode layer are laminated in this order, on one main surface of a support substrate extending in one direction, at predetermined intervals in the one direction; an affixing step of affixing a sealing member extending in the one direction along the one direction such that a part of each of the first electrode layer and the second electrode layer in each of the organic device units is exposed and the sealing member straddles across the plurality of organic device units; and a cutting step of dividing the plurality of organic device units to which sealing member is affixed, in which in the affixing step, the sealing member including a sealing base material containing a material having conductivity, and an adhesive portion containing a pressure-sensitive adhesive is affixed to the organic device unit, and in the cutting step, a cutting blade is allowed to approach from the sealing member side, and the sealing member is cut such that the adhesive portion after being cut protrudes to the outside from the sealing base material.

In the method for manufacturing an organic device according to one aspect of the present invention, in the cutting step, the cutting blade is allowed to approach from the sealing member side, and the sealing member is cut such that the adhesive portion after being cut protrudes to the outside from the sealing base material. As described above, the adhesive portion is allowed to protrude to the outside from the sealing base material, and thus, even in a case where the sealing base material containing the material having conductivity is dragged to the cutting blade, it is possible to prevent the first electrode layer and/or the second electrode layer, and the sealing member from being in contact with each other (from being electrically connected to each other) by the adhesive portion. Therefore, it is possible to prevent the first electrode layer and the second electrode layer from being electrically connected to each other via the sealing base material, and thus, to prevent a short circuit from occurring. As a result thereof, in the method for manufacturing an organic device, it is possible to suppress a decrease in reliability.

In one embodiment, in the cutting step, the cutting blade having a single-edge blade structure may be used, a surface of the cutting blade having a smaller inclination angle with respect to an approach direction of the cutting blade may be positioned on the organic device unit side, and the cutting blade may be allowed to approach the sealing member. The cutting blade applies a pressure with respect to the sealing member at the time of approaching the sealing member. The pressure that is applied with respect to the sealing member by the inclined surface of the cutting blade increases as the cutting blade approaches the sealing member. The pressure that is applied by the cutting blade is larger in a surface having a larger inclination angle with respect to a forward direction than in the surface having a smaller inclination angle. Therefore, in a case where the surface of the cutting blade having a smaller inclination angle is positioned on the organic device unit side, and the cutting blade is allowed to approach the sealing member, the adhesive portion in the sealing member that is positioned on the surface side having a larger inclination angle is moved to the surface side having a smaller inclination angle by the pressure that is applied from the surface side of the cutting blade having a larger inclination angle. After the sealing member is cut, the adhesive portion that is moved to the surface side having a smaller inclination angle tries to return to the position before cutting, and as a result thereof, the adhesive portion protrudes to the outside from the sealing base material. As described above, it is possible to allow the adhesive portion to protrude to the outside from the sealing base material.

An organic device according to one aspect of the present invention, includes: an organic device unit in which at least a first electrode layer, an organic functional layer, and a second electrode layer are laminated in this order, on a support substrate; and a sealing member disposed on the organic device unit such that a part of each of the first electrode layer and the second electrode layer in the organic device unit is exposed, in which the sealing member is configured by laminating at least a sealing base material containing a material having conductivity, and an adhesive portion containing a pressure-sensitive adhesive, and the adhesive portion protrudes to the outside from the sealing base material.

In the organic device according to one aspect of the present invention, the adhesive portion protrudes to the outside from the sealing base material. Accordingly, it is possible to prevent the first electrode layer and/or the second electrode layer, and the sealing member from being in contact with each other (from being electrically connected to each other) by the adhesive portion. Therefore, it is possible to prevent the first electrode layer and the second electrode layer from being electrically connected to each other via the sealing base material, and thus, to prevent a short circuit from occurring. As a result thereof, in the organic device, it is possible to suppress a decrease in the reliability.

### Advantageous Effects of Invention

According to one aspect of the present invention, it is possible to suppress a decrease in the reliability.

### Brief Description of Drawings

FIG. 1 is a diagram illustrating a sectional configuration of an organic light-emitting diode that is manufactured by a method for manufacturing an organic device according to one embodiment.
FIG. 2 is a diagram illustrating the sectional configuration of the organic light-emitting diode.
FIG. 3 is a flowchart illustrating a method for manufacturing an organic light-emitting diode.
FIG. 4 is a perspective view illustrating a state in which a sealing member is affixed to an organic device unit.
FIG. 5 is a diagram for describing a cutting step.
FIG. 6 is a diagram for describing the cutting step.
FIG. 7 is a diagram illustrating a cutting unit.
FIG. 8 is a diagram illustrating a configuration of a cutting blade.
FIG. 9(a), FIG. 9(b), and FIG. 9(c) are diagrams for describing the cutting step in detail.
FIG. 10 is a diagram illustrating a cutting unit according to a modification example.
FIG. 11 is a diagram illustrating a measurement result.
FIG. 12 is a diagram illustrating the measurement result.

### Description of Embodiments

Hereinafter, a preferred embodiment of the present invention will be described in detail, with reference to the attached drawings. In the description of the drawings, the same reference numerals will be applied to the same or the corresponding constituents, and the repeated description will be omitted.

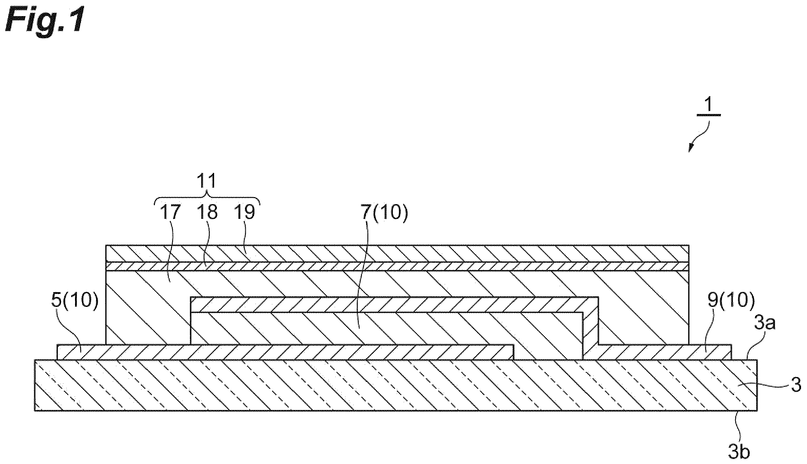

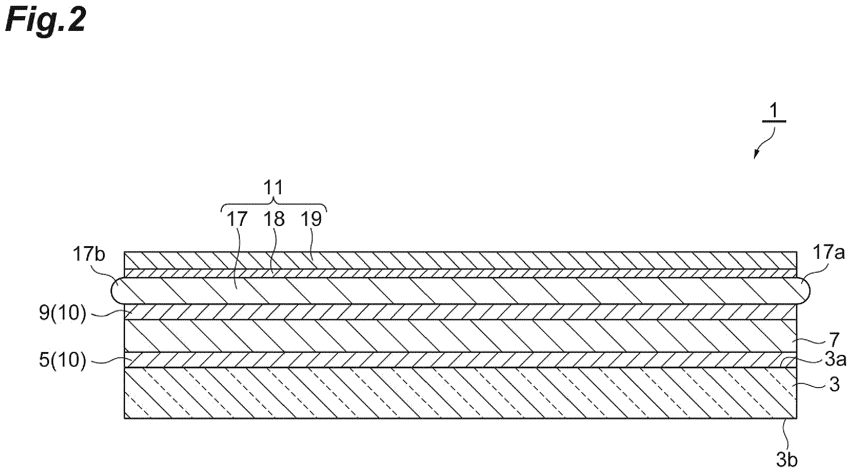

As illustrated in FIG. 1 and FIG. 2, an organic light-emitting diode (an organic device) 1 that is manufactured by a method for manufacturing an organic device of this embodiment includes a support substrate 3, a anode layer (a first electrode layer) 5, an organic functional layer 7, a cathode layer (a second electrode layer) 9, and a sealing member 11. The anode layer 5, the organic functional layer 7, and the cathode layer 9 configure the organic EL unit (the organic device unit) 10. Hereinafter, unless otherwise noted, a bottom emission type organic light-emitting diode 1 will be described. However, the organic light-emitting diode 1 may be a top emission type device.

### [Support Substrate]

The support substrate 3 is configured of a resin having light transmissivity with respect to visible light (light having a wavelength of 400 nm to 800 nm). The support substrate 3 is a film-like substrate (a flexible substrate or a substrate having flexibility). The thickness of the support substrate 3, for example, is greater than or equal to 30 µm and less than or equal to 500 µm. In a case where the support substrate 3 is the resin, it is preferable that the thickness of the support substrate 3 is greater than or equal to 45 µm from the viewpoint of the twist, the wrinkle, and the stretch of the substrate in a continuous roll-to-roll method, and is less than or equal to 125 µm from the viewpoint of the flexibility.

The support substrate 3, for example, is a plastic film. Examples of the material of the support substrate 3 include a polyester resin such as polyether sulfone (PES); polyethylene terephthalate (PET), and polyethylene naphthalate (PEN); a polyolefin resin such as polyethylene (PE), polypropylene (PP), and cyclic polyolefin; a polyamide resin; a polycarbonate resin; a polystyrene resin; a polyvinyl alcohol resin; a saponified product of an ethylene-vinyl acetate copolymer; a polyacrylonitrile resin; an acetal resin; a polyimide resin; an epoxy resin, and the like.

Among the resins described above, the polyester resin or the polyolefin resin is preferable, and polyethylene terephthalate or polyethylene naphthalate is more preferable, as the material of the support substrate 3, from the viewpoint of high heat resistance and a low linear expansion coefficient, and a low manufacturing cost. Only one type of such resins may be used, or two or more types thereof may be used by being combined.

A gas barrier layer or moisture barrier layer may be disposed on one main surface 3a of the support substrate 3. The other main surface 3b of the support substrate 3 is a light emitting surface. A light extraction film may be provided on the other main surface 3b of the support substrate 3. The light extraction film may be affixed to the other main surface 3b of the support substrate 3 by an adhesive layer. The support substrate 3 may be thin film glass. In a case where the support substrate 3 is the thin film glass, it is preferable that the thickness thereof is greater than or equal to 30 µm from the viewpoint of a strength, and is less than or equal to 100 µm from the viewpoint of the flexibility.

### [Anode Layer]

The anode layer 5 is disposed on one main surface 3a of the support substrate 3. An electrode layer exhibiting light transmittance is used in the anode layer 5. A thin film of a metal oxide, a metal sulfide, a metal, and the like, having a high electric conductivity, can be used as the electrode exhibiting light transmittance, and a thin film having a high light transmission rate is preferably used. For example, a thin film formed of indium oxide, zinc oxide, tin oxide, indium tin oxide (abbreviated as ITO), indium zinc oxide (abbreviated as IZO), gold, platinum, silver, copper, and the like is used, and among them, a thin film formed of ITO, IZO, or tin oxide is preferably used.

A transparent conductive film of an organic substance such as polyaniline and derivatives thereof, and polythiophene and derivatives thereof may be used as the anode layer 5. An electrode in which the metals described above, metal alloys, or the like are patterned into the shape of a mesh, or an electrode in which a nanowire containing silver is formed into the shape of a network may be used as the anode layer 5.

The thickness of the anode layer 5 can be determined in consideration of the light transmittance, the electric conductivity, and the like. The thickness of the anode layer 5 is generally 10 nm to 10 µm, is preferably 20 nm to 1 µm, and is more preferably 50 nm to 200 nm.

Examples of a forming method of the anode layer 5 are capable of including a dry film forming method such as a vacuum vapor deposition method, a sputtering method, and an ion plating method, and a coating method such as an ink jet method, a slit coater method, a gravure printing method, a screen printing method, and a spray coater method. In the anode layer 5, a pattern can be formed by further using a photolithography method, a dry etching method, a laser trimming method, and the like. The support substrate 3 is directly subjected to coating by using a coating method, and thus, it is also possible to form a pattern without using the photolithography method, the dry etching method, the laser trimming method, and the like.

### [Organic Functional Layer]

The organic functional layer 7 is disposed on a main surface of the anode layer 5 (on a side opposite to a surface in contact with the support substrate 3) and one main surface 3a of the support substrate 3. The organic functional layer 7 includes a light emitting layer. In general, the organic functional layer 7 includes a light emitting material mainly emitting fluorescence and/or phosphorescence, or the light emitting material and a dopant material for a light emitting layer that assists the light emitting material. The dopant material for a light emitting layer, for example, is added in order to improve a light emitting efficiency or to change a light emitting wavelength. The light emitting material emitting fluorescence and/or phosphorescence may be a low-molecular compound, or may be a high-molecular compound. Examples of the organic substance configuring the organic functional layer 7 are capable of including the light emitting material emitting fluorescence and/or phosphorescence, such as a dye material, a metal complex material, and a high-molecular material, described below, the dopant material for a light emitting layer described below, or the like.

### (Dye Material)

Examples of the dye material are capable of including cyclopendamine and derivatives thereof, tetraphenyl butadiene and derivatives thereof, triphenyl amine and derivatives thereof, oxadiazole and derivatives thereof, pyrazoloquinoline and derivatives thereof, distyryl benzene and derivatives thereof, distyryl arylene and derivatives thereof, pyrrole and derivatives thereof, a thiophene compound, a pyridine compound, perynone and derivatives thereof, perylene and derivatives thereof, oligothiophene and derivatives thereof, an oxadiazole dimer, a pyrazoline dimer, quinacridone and derivatives thereof, coumarin and derivatives thereof, and the like.

### (Metal Complex Material)

Examples of the metal complex material are capable of including a metal complex having a rare-earth metal such as Tb, Eu, and Dy, or Al, Zn, Be, Pt, Ir, and the like in a central metal, and oxadiazole, thiadiazole, phenyl pyridine, phenyl benzimidazole, a quinoline structure, and the like in a ligand, and the like. Examples of the metal complex are capable of including a metal complex emitting light from a triplet excited state, such as an iridium complex and a platinum complex, an aluminum quinolinol complex, a benzoquinolinol beryllium complex, a benzooxazolyl zinc complex, a benzothiazole zinc complex, an azomethyl zinc complex, a porphyrin zinc complex, a phenanthroline europium complex, and the like.

### (High-Molecular Material)

Examples of the high-molecular material are capable of including polyparaphenylene vinylene and derivatives thereof, polythiophene and derivatives thereof, polyparaphenylene and derivatives thereof, polysilane and derivatives thereof, polyacetylene and derivatives thereof, polyfluorene and derivatives thereof, polyvinyl carbazole and derivatives thereof, a material in which the dye materials or the metal complex materials described above are polymerized, and the like.

### (Dopant Material for Light Emitting Layer)

Examples of the dopant material for a light emitting layer are capable of including perylene and derivatives thereof, coumarin and derivatives thereof, rubrene and derivatives thereof, quinacridone and derivatives thereof, squarylium and derivatives thereof, porphyrin and derivatives thereof, a styryl dye, tetracene and derivatives thereof, pyrazolone and derivatives thereof, decacyclene and derivatives thereof, phenoxazone and derivatives thereof, and the like.

In general, the thickness of the organic functional layer 7 is approximately 2 nm to 200 nm. The organic functional layer 7, for example, is formed by a coating method using a coating liquid (for example, an ink) containing the light emitting material as described above. A solvent of the coating liquid containing the light emitting material is not limited insofar as the light emitting material is dissolved in the solvent. The light emitting material as described above may be formed by vacuum vapor deposition.

### [Cathode Layer]

The cathode layer 9 is disposed on a main surface of the organic functional layer 7 (on a side opposite to a surface in contact with the anode layer 5) and one main surface 3a of the support substrate 3. For example, an alkaline metal, an alkaline-earth metal, a transition metal, metals of the group 13 metal in the periodic table, and the like can be used as the material of the cathode layer 9. Specifically, for example, metals such as lithium, sodium, potassium, rubidium, cesium, beryllium, magnesium, calcium, strontium, barium, aluminum, scandium, vanadium, zinc, yttrium, indium, cerium, samarium, europium, terabium, and ytterabium, alloys of two or more types of metals described above, alloys of one or more types of metals described above and one or more types of gold, silver, platinum, copper, manganese, titanium, cobalt, nickel, tungsten, and tin, graphite or a graphite intercalation compound, and the like are used as the material of the cathode layer 9. Examples of the alloy are capable of including a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy, and the like.

For example, a transparent conductive electrode formed of a conductive metal oxide, a conductive organic substance, and the like can be used as the cathode layer 9. Specifically, examples of conductive metal oxide are capable of including indium oxide, zinc oxide, tin oxide, ITO, IZO, and the like, and examples of the conductive organic substance are capable of including polyaniline and derivatives thereof, polythiophene and derivatives thereof, and the like. The cathode layer 9 may be configured of a laminated body in which two or more layers are laminated. An electron injection layer described below may be used as the cathode layer 9.

The thickness of the cathode layer 9 is set in consideration of an electric conductivity and durability. The thickness of the cathode layer 9 is generally 10 nm to 10 µm, is preferably 20 nm to 1 µm, and is more preferably 50 nm to 500 nm.

Examples of a forming method of the cathode layer 9 are capable of including a coating method such as an ink jet method, a slit coater method, a gravure printing method, a screen printing method, and a spray coater method, a vacuum vapor deposition method, a sputtering method, a laminating method of performing thermal compression bonding with respect to a metal thin film, and the like, and the vacuum vapor deposition method or the sputtering method is preferable.

### [Sealing Member]

The sealing member 11 is disposed on the uppermost layer in the organic light-emitting diode 1 to cover at least the organic functional layer 7. The sealing member 11 includes an adhesive portion 17 and a sealing base material 19. The sealing member 11 may include the adhesive portion 17, a barrier layer 18, and the sealing base material 19. In a case where the sealing member 11 includes the adhesive portion 17, the barrier layer 18, and the sealing base material 19, in the sealing member 11, the adhesive portion 17, the barrier layer 18, and the sealing base material 19 are laminated in this order. In the configuration, the adhesive portion 17 is used for bonding the barrier layer 18 and the sealing base material 19 to the anode layer 5, the organic functional layer 7, and the cathode layer 9.

Specifically, the adhesive portion 17 is a pressure-sensitive adhesive. The pressure-sensitive adhesive preferably contains an α-olefin-based resin and a tackifier. The α-olefin-based resin and the tackifier are not particularly limited, and known materials of the related art can be used. Examples of the α-olefin-based resin include a homopolymer such as polyethylene and polyisobutylene, a copolymer, or the like. Examples of the copolymer include a copolymer obtained by polymerizing two or more types of α-olefins, a copolymer obtained by polymerizing α-olefin and a monomer other than α-olefin (for example, styrene, non-conjugated diene, or the like), and the like. The pressure-sensitive adhesive may contain additives. Examples of the additive include a hygroscopic metal oxide (for example, calcium oxide, calcined hydrotalcite, and the like), and an inorganic filler other than the hygroscopic metal oxide (for example, silica, mica, talc, and the like).

The barrier layer 18 or the sealing base material 19 has a gas barrier function, in particular, a moisture barrier function. Examples of the barrier layer 18 include a film formed of a silicon oxide (SiOx), an aluminum oxide (Al₂O_{X}), or a titanium oxide (TiOx). The sealing base material 19 includes a material having conductivity. The sealing base material 19, for example, include a metal foil. Copper, aluminum, or stainless steel is preferable as the metal foil, from the viewpoint of barrier properties. It is preferable that the thickness of the metal foil is large from the viewpoint of suppressing a pinhole, but it is preferable that the thickness of the metal foil is 10 µm to 50 µm from the viewpoint of flexibility. In a case where the sealing base material 19 include the metal foil, the barrier layer 18 may be omitted.

The sealing base material 19 may be formed only of the metal foil, or may be formed of a plurality of layers including the metal foil. In a case where the sealing base material 19 is formed of the plurality of layers, for example, a plastic film may be bonded to the surface of the sealing base material 19 on a side opposite to the surface on which the barrier layer 18 or the adhesive portion 17 is formed. Examples of the plastic film to be bonded include a polyester resin such as polyether sulfone (PES); polyethylene terephthalate (PET), and polyethylene naphthalate (PEN); a polyolefin resin such as polyethylene (PE), polypropylene (PP), and cyclic polyolefin; a polyamide resin; a polycarbonate resin; a polystyrene resin; a polyvinyl alcohol resin; a saponified product of an ethylene-vinyl acetate copolymer; a polyacrylonitrile resin; an acetal resin; a polyimide resin; an epoxy resin, and the like. Accordingly, a mode can be attained in which a material having conductivity is not exposed to the outside.

In this embodiment, as illustrated in FIG. 2, the adhesive portion 17 protrudes from the sealing base material 19. Specifically, the adhesive portion 17 includes protruding portions 17a and 17b. The protruding portions 17a and 17b are provided in the adhesive portion 17, in a second direction (a horizontal direction in FIG. 2) orthogonal to a first direction (a horizontal direction in FIG. 1) in which the exposed portion of the anode layer 5 and the cathode layer 9 is disposed. The protruding portions 17a and 17b protrude to the outside in the second direction from the end surface of the sealing base material 19. A protruding amount of the protruding portions 17a and 17b is suitably set.

### [Method for Manufacturing Organic light-emitting diode]

Subsequently, the method for manufacturing the organic light-emitting diode 1 having the configuration described above will be described.

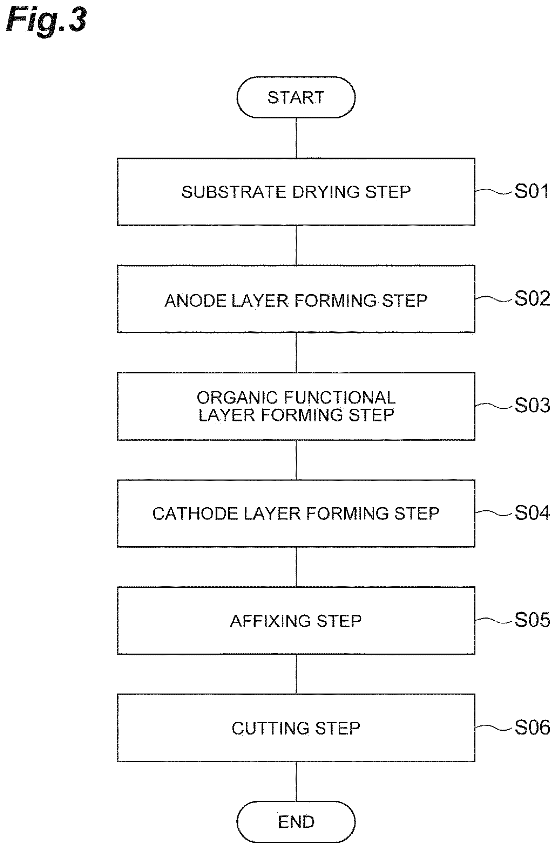

In a mode where the support substrate 3 is a substrate that has flexibility and extends in a longitudinal direction, a roll-to-roll method can be adopted to a substrate drying step S01 to an affixing step S05 illustrated in FIG. 3.

In a case where the organic light-emitting diode 1 is manufactured, first, the support substrate 3 is heated and dried (the substrate drying step S01). Next, the anode layer 5 is formed on one main surface 3a of the support substrate 3 that is dried (a anode layer forming step (a forming step) S02). The anode layer 5 can be formed by the forming method that is exemplified in the description of the anode layer 5. A plurality of anode layers 5 are formed in a longitudinal direction of the support substrate 3, at predetermined intervals, and a plurality of (in this embodiment, two) anode layers 5 are formed in a width direction of the support substrate 3 (the other direction orthogonal to one direction), at predetermined intervals, on the support substrate 3.

Subsequently, the organic functional layer 7 is formed on the anode layer 5 (an organic functional layer forming step (a forming step) S03). The organic functional layer 7 can be formed by the forming method that is exemplified in the description of the organic functional layer 7. Next, the cathode layer 9 is formed on the organic functional layer 7 (a cathode layer forming step (a forming step) S04). The cathode layer 9 can be formed by the forming method that is exemplified in the description of the cathode layer 9. As described above, as illustrated in FIG. 3, a plurality of organic EL units 10 are formed in the longitudinal direction of the support substrate 3 (a Y direction in FIG. 3), at predetermined intervals, and a plurality of (in this embodiment, two) organic EL units 10 are formed in the width direction of the support substrate 3 (an X direction in FIG. 3), at predetermined intervals, on the support substrate 3. That is, two rows of organic EL units 10 are formed along the longitudinal direction of the support substrate 3, on the support substrate 3.

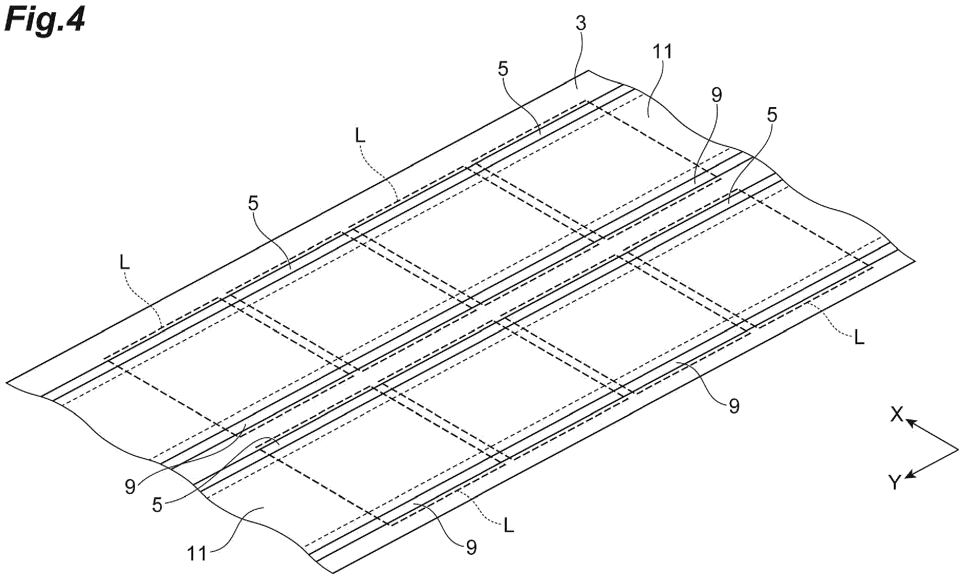

Subsequently, the sealing member 11 is affixed (the affixing step S05). The sealing member 11 has a predetermined width and extends in the longitudinal direction of the support substrate 3. Specifically, as illustrated in FIG. 4, the width of the sealing member 11 is set such that a part of each of the anode layer 5 and the cathode layer 9 is exposed, and the sealing member 11 is in the shape of a strip. The sealing member 11 has flexibility. In the sealing member 11, the adhesive portion 17 is provided on one surface of the sealing base material 19. The sealing member 11 may be cut into the shape of a strip after the adhesive portion 17 is formed on one surface of the sealing base material 19 through the barrier layer 18, or the adhesive portion 17 may be formed on one surface of the sealing base material 19 through the barrier layer 18 after the sealing base material 19 is cut into the shape of a strip.

The sealing member 11 is pasted onto the organic EL unit 10 such that a part of the anode layer 5 and a part of the cathode layer 9 are exposed. Specifically, the sealing member 11 is pasted along one direction across the plurality of organic EL units 10. In the roll-to-roll method, the organic EL unit 10 formed on the support substrate 3 and the sealing member 11 are affixed to each other while the support substrate 3 is transported. The support substrate 3 and the sealing member 11 pass between rollers (not illustrated). Accordingly, a pressure is applied to the support substrate 3 and the sealing member 11 by the rollers. Accordingly, the adhesive portion 17 and the organic EL unit 10 are stuck to each other. When the organic EL unit 10 and the sealing member 11 are affixed to each other, it is preferable that the affixment is performed in an environment where a moisture concentration is low, and it is particularly preferable that the affixment is performed in a nitrogen atmosphere.

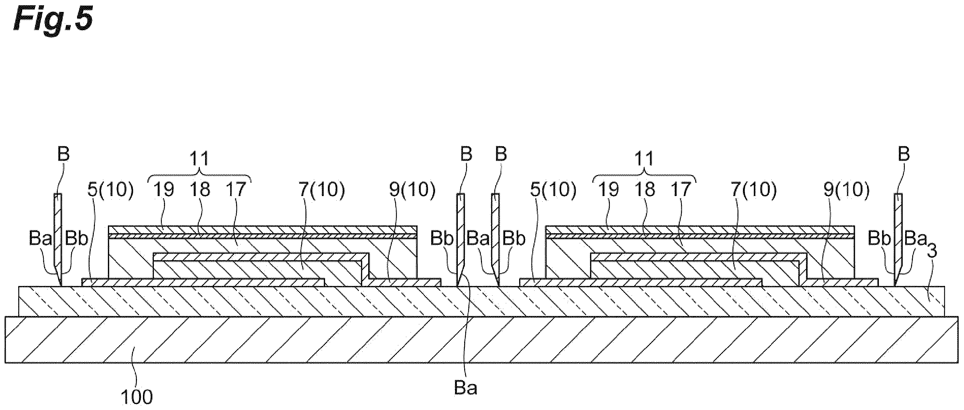

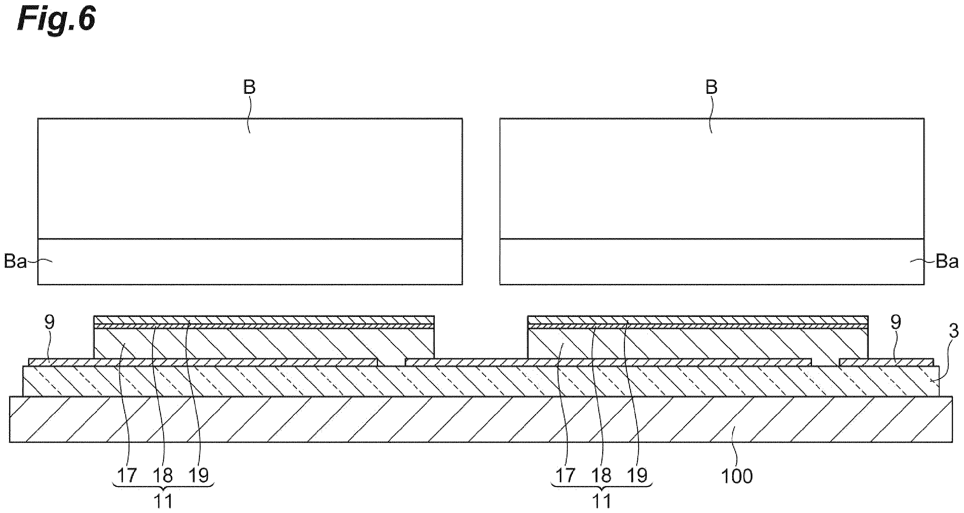

Subsequently, the plurality of organic EL units 10 to which the sealing member 11 is affixed are divided (a cutting step S06). As illustrated in FIG. 4, in the cutting step S06, the support substrate 3 and the sealing member 11 are cut along a cutting line L, and thus, the plurality of organic EL units 10 to which the sealing member 11 is affixed are divided. Specifically, as illustrated in FIG. 5 and FIG. 6, the support substrate 3 is supported on a support body 100, and the support substrate 3 is cut by a cutting blade B. FIG. 5 is a diagram of a sectional surface along the X direction of FIG. 4 when seen from the Y direction, and illustrates a sectional surface in a position including the anode layer 5 and the organic functional layer 7. FIG. 6 is a diagram of the sectional surface along the X direction of FIG. 4 when seen from the Y direction, and illustrates a sectional surface of a position not including the anode layer 5 and the organic functional layer 7.

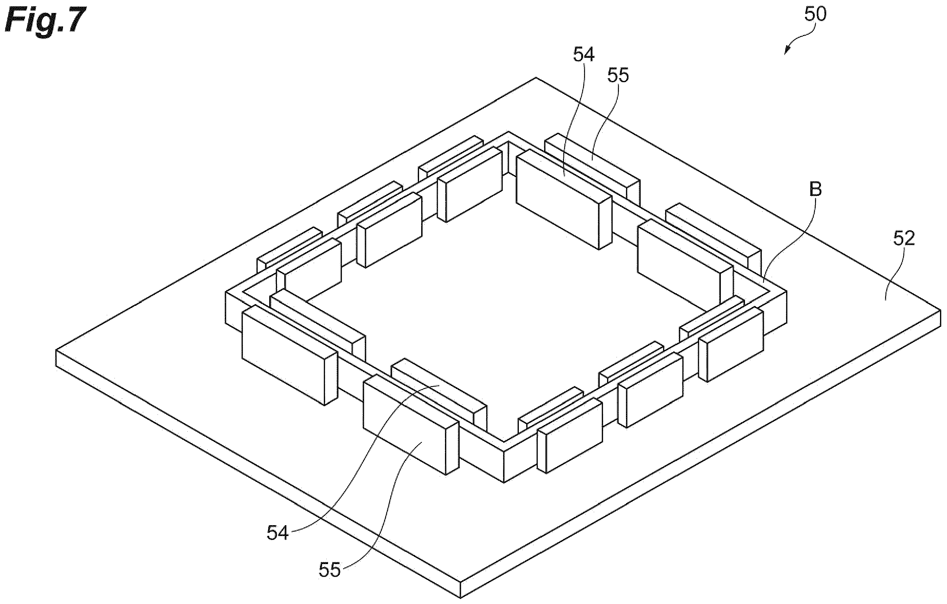

As illustrated in FIG. 7, the cutting blade B is provided in a cutting unit 50. The cutting unit 50 includes the cutting blade B, a retaining portion (a base portion) 52 retaining the cutting blade B, and elastic members 54 and 55. The retaining portion 52, for example, is a plate member such as plywood. The cutting blade B has a shape according to the cutting line L, and is in the shape of a frame. In this embodiment, in the cutting blade B, four blade members are integrally provided. In the cutting blade B, for example, an end portion of the cutting blade B on the retaining portion 52 side is embedded in the retaining portion 52, and thus, is retained by the retaining portion 52. As another example, the cutting blade B may be a blade that is carved by machining a part of the retaining portion 52 with a numerical control (NC) processing machine, and the cutting blade B may be integrated with the retaining portion 52. In this case, the cutting blade B and the retaining portion 52 can be formed of the same material.

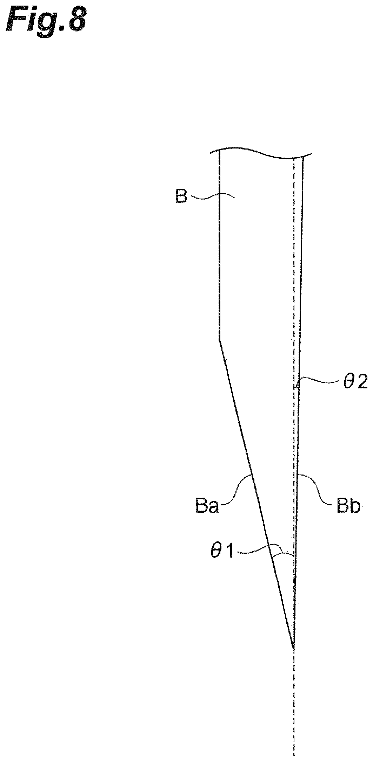

As illustrated in FIG. 8, the cutting blade B has a single-edge blade structure. Herein, the single-edge blade structure is a structure in which one blade surface and the other blade surface are inclined, and the other blade surface has a smaller inclination angle than that of the one blade surface. The cutting blade B includes a first blade surface Ba and a second blade surface Bb.

The first blade surface Ba is at an inclination angle θ1 with respect to a straight line along a height direction of the cutting blade B. The second blade surface Bb is at an inclination angle θ2 with respect to the straight line along the height direction of the cutting blade B. The inclination angle θ1 of the first blade surface Ba is larger than the inclination angle θ2 of the second blade surface Bb. In other words, the inclination angle θ2 of the second blade surface Bb is smaller than the inclination angle θ1 of the first blade surface Ba. The inclination angle θ1 is preferably greater than 15°, and is more preferably greater than or equal to 30°, from the viewpoint of facilitating the protrusion of the adhesive portion 17 to the outside from the sealing base material 19 after cutting. The inclination angle θ1 is preferably less than 50°, and is more preferably less than or equal to 40°, from the viewpoint of suppressing the modification of the sealing base material 19. In the cutting step S06, it is preferable that the inclination angle θ2 is greater than or equal to 0° and less than 15°, from the viewpoint of suppressing the modification of the sealing member 11.

In one embodiment, the first blade surface Ba of the cutting blade B is at the inclination angle θ1 of approximately 40° with respect to the straight line along the height direction of the cutting blade B. The second blade surface Bb is at the inclination angle θ2 of approximately 1° with respect to the straight line along the height direction of the cutting blade B. That is, the second blade surface Bb of the cutting blade B has an inclination angle smaller than that of the first blade surface Ba, with respect to an approach direction of the inclination angle cutting blade B.

In a case where the cutting blade approaches a cutting target, a pressure is applied from the cutting target. Specifically, in a case where the cutting blade approaches the cutting target, a pressure is applied in a width direction of the cutting blade. In a cutting blade having a structure in which one blade surface is inclined, and the other blade surface is not inclined, a pressure to be applied to the surface that is inclined increases as the cutting blade approaches the cutting target. At this time, a pressure is rarely applied to the surface that is not inclined. For this reason, the pressure with respect to the surface that is inclined increases as the cutting blade approaches the cutting target, and thus, the cutting blade may be bent in the approach direction. As a result thereof, there is a concern that it is not possible to accurately cut the cutting target.

In the cutting blade B of this embodiment, both surfaces of the first blade surface Ba and the second blade surface Bb are inclined. Accordingly, both surfaces of the first blade surface Ba and the second blade surface Bb receive a pressure. Accordingly, a part of the pressure that is received by the first blade surface Ba can be offset by the pressure that is received by the second blade surface Bb, with respect to the sealing member 11. Therefore, it is possible to allow the cutting blade B to straightly approach. As a result thereof, it is possible to accurately cut the sealing member 11 by the cutting blade B.

The cutting blade B is disposed such that the second blade surface Bb faces the inside. In this embodiment, in the cutting blade B in the shape of a frame, the second blade surfaces Bb are disposed to face each other. In the cutting blade B of this embodiment, the second blade surface Bb is disposed to face the elastic member 54 (the first blade surface Ba is disposed to face the elastic member 55).

Examples of the material of the elastic members 54 and 55 include rubber, a sponge, and the like. The elastic members 54 and 55 are fixed to the retaining portion 52. As one embodiment, in the cutting step S06, the elastic members 54 and 55 are disposed to each other as a pair in a position in which the cutting blade B is interposed between the elastic members, from the viewpoint of easily pressing the support substrate 3. In this embodiment, a plurality of (here, ten) sets of elastic members 54 and 55 are provided at predetermined intervals. As illustrated in FIG. 7, tip end portions of the elastic members 54 and 55 (end portions on a side opposite to end portions that are joined to the retaining portion 52) protrude from a tip end (a blade edge) of the cutting blade B.

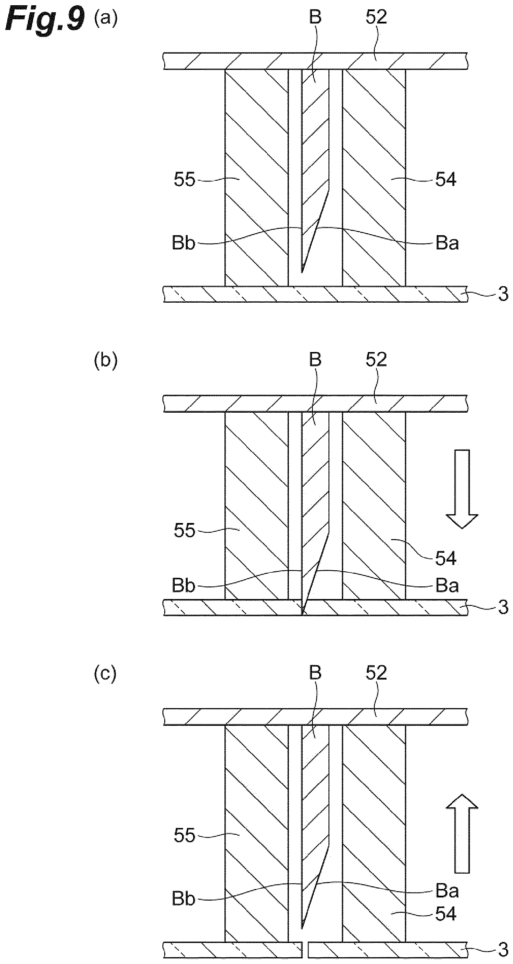

The action (the function) of the elastic members 54 and 55 will be described with reference to FIG. 9(a) to FIG. 9(c). In FIG. 9(a) to FIG. 9(c), a mode of cutting the support substrate 3 will be described as an example. As illustrated in FIG. 9(a), the cutting blade B is positioned in a cutting portion. At this time, the elastic members 54 and 55 of which the tip end portion protrudes from the cutting blade B press the support substrate 3. As illustrated in FIG. 9(b), in a case where the cutting blade B is allowed to approach the support substrate 3, the elastic members 54 and 55 are interposed between the support substrate 3 and the retaining portion 52, and are contracted by being depressed with the retaining portion 52. Then, as illustrated in FIG. 9(c), in a case where the cutting blade B cuts the support substrate 3 and returns to the original position, the elastic members 54 and 55 extend and also return to the original state. When the cutting blade B is retracted from the support substrate 3, the support substrate 3 is depressed by the elastic members 54 and 55. Accordingly, when the cutting blade B is lifted up from the support substrate 3, the support substrate 3 is prevented from being pulled up by the cutting blade B, and thus, the support substrate 3 is prevented from being warped up. When the cutting blade B cuts the sealing member 11, the organic EL unit 10, and the support substrate 3, it is possible to prevent the sealing base material 19 of the sealing member 11 from being warped up. In the cutting step S06, a plurality of cutting units 50 having the configuration as described above are used. Accordingly, in the cutting step S06, it is possible to divide the plurality of organic light-emitting diodes 1 at one time.

In the cutting step S06, as illustrated in FIG. 5 and FIG. 6, the support substrate 3 on which the plurality of organic EL units 10 are formed is supported on the support body 100. Then, the cutting blade B of the cutting unit 50 is allowed to approach from one main surface 3a side of the support substrate 3, and to approach from the sealing member 11 side in a region where the sealing member 11 is affixed. The cutting blade B is allowed to approach the sealing member 11 such that the second blade surface Bb is directed towards the organic EL unit 10 side (a side in which the organic EL unit 10 is formed). The tip end of the cutting blade B advances towards a position reaching the other main surface 3b of the support substrate 3. While the cutting blade B advances, the adhesive portion positioned on the first blade surface Ba side is moved to the second blade surface Bb side by a pressure that is applied from the first blade surface Ba side of the cutting blade B. After the sealing member 11 is cut, the adhesive portion that is moved to the second blade surface Bb side tries to return to the position before the cutting, and thus, the adhesive portion 17 protrudes to the outside from the sealing base material 19. Through the steps described above, the plurality of organic EL units 10 to which the sealing member 11 is affixed are divided. As described above, the organic light-emitting diode 1 illustrated in FIG. 1 and FIG. 2 is manufactured.

As described above, in the method for manufacturing the organic light-emitting diode 1 according to this embodiment, in the cutting step S06, the cutting blade B is allowed to approach from the sealing member 11 side, and cuts the sealing member 11 such that the adhesive portion 17 after being cut protrudes to the outside from the sealing base material 19. As described above, the adhesive portion 17 is allowed to protrude to the outside from the sealing base material 19, and thus, even in a case where the sealing base material 19 containing a material having conductivity is dragged to the cutting blade B, it is possible to prevent the anode layer 5 and/or the cathode layer 9, and the sealing member 11 from being in contact with each other (from being electrically connected to each other) by the adhesive portion 17. Therefore, it is possible to prevent the anode layer 5 and the cathode layer 9 from being electrically connected to each other via the sealing base material 19, and thus, to prevent a short circuit from occurring. As a result thereof, in the method for manufacturing the organic light-emitting diode 1, it is possible to suppress a decrease in the reliability.

In the method for manufacturing organic light-emitting diode 1 according to this embodiment, in the cutting step S06, the cutting blade B having a single-edge blade structure is used, and in the cutting blade B, the second blade surface Bb having a smaller inclination angle with respect to the approach direction of the cutting blade B is positioned on the organic EL unit 10 side, and the cutting blade B is allowed to approach the sealing member 11. The cutting blade B applies a pressure with respect to the sealing member 11 at the time of approaching the sealing member 11. The pressure that is applied to the sealing member 11 by the inclined surface of the cutting blade B increases as the cutting blade B approaches the sealing member 11. The pressure that is applied by the cutting blade B is larger in the first blade surface Ba having a larger inclination angle with respect to the forward direction than in the second blade surface Bb having a smaller inclination angle. Therefore, in a case where the second blade surface Bb of the cutting blade B having a smaller inclination angle is positioned on the organic EL unit 10 side, and the cutting blade B is allowed to approach the sealing member 11, the adhesive portion in the sealing member 11 that is positioned on the first blade surface Ba side is moved to the second blade surface Bb side by the pressure that is applied from the first blade surface Ba side of the cutting blade B having a larger inclination angle. After the sealing member 11 is cut, the adhesive portion that is moved to the second blade surface Bb side tries to return to the position before the cutting, and as a result thereof, the adhesive portion 17 protrudes to the outside from the sealing base material 19. As described above, it is possible to allow the adhesive portion 17 to protrude to the outside from the sealing base material 19.

In the organic light-emitting diode 1 that is obtained by the manufacturing method or the like according to this embodiment, the adhesive portion 17 protrudes to the outside from the sealing base material 19. As described above, the adhesive portion 17 protrudes to the outside from the sealing base material 19, and thus, even in a case where the sealing base material 19 containing the material having conductivity is dragged to the cutting blade B, it is possible to prevent the anode layer 5 and/or the cathode layer 9, and the sealing member 11 from being in contact with each other (from being electrically connected to each other). Therefore, it is possible to prevent the anode layer 5 and the cathode layer 9 from being electrically connected to each other via the sealing base material 19, and to prevent a short circuit from occurring. As a result thereof, in the organic light-emitting diode 1, it is possible to suppress a decrease in the reliability.

As described above, the embodiment of the present invention has been described, but the present invention is not limited to the embodiment described above, and can be variously changed within a range not departing from the gist thereof.

For example, in the embodiment described above, the organic light-emitting diode 1 in which the organic functional layer 7 including the light emitting layer is disposed between the anode layer 5 and the cathode layer 9 has been exemplified. However, the configuration of the organic functional layer 7 is not limited thereto. The organic functional layer 7 may have the following configurations.
(a) (Anode Layer)/Light Emitting Layer/(Cathode Layer)
(b) (Anode Layer)/Hole Injection Layer/Light Emitting Layer/(Cathode Layer)
(c) (Anode Layer)/Hole Injection Layer/Light Emitting Layer/Electron Injection Layer/(Cathode Layer)
(d) (Anode Layer)/Hole Injection Layer/Light Emitting Layer/Electron Transport Layer/Electron Injection Layer/(Cathode Layer)
(e) (Anode Layer)/Hole Injection Layer/Hole Transport Layer/Light Emitting Layer/(Cathode Layer)
(f) (Anode Layer)/Hole Injection Layer/Hole Transport Layer/Light Emitting Layer/Electron Injection Layer/(Cathode Layer)
(g) (Anode Layer)/Hole Injection Layer/Hole Transport Layer/Light Emitting Layer/Electron Transport Layer/Electron Injection Layer/(Cathode Layer)
(h) (Anode Layer)/Light Emitting Layer/Electron Injection Layer/(Cathode Layer)
(i) (Anode Layer)/Light Emitting Layer/Electron Transport Layer/Electron Injection Layer/(Cathode Layer)

Here, a symbol "/" indicates that the respective layers interposing the symbol "/" therebetween are laminated adjacent to each other. The configuration in (a) described above indicates the configuration of the organic light-emitting diode 1 in the embodiment described above.

Known materials can be used as the material of each of the hole injection layer, the hole transport layer, the electron transport layer, and the electron injection layer. Each of the hole injection layer, the hole transport layer, the electron transport layer, and the electron injection layer, for example, can be formed by the same coating method as that of the organic functional layer 7.

Here, the electron injection layer may contain an alkaline metal or an alkaline-earth metal, an oxide of an alkaline metal or an alkaline-earth metal, and a fluoride. Examples of a film forming method of the electron injection layer are capable of including a coating method, a vacuum vapor deposition method, and the like. In a case of the oxide and the fluoride, it is preferable that the thickness of the electron injection layer is 0.5 nm to 20 nm. In particular, in a case where the electron injection layer has strong insulating properties, it is preferable that the electron injection layer is a thin film, from the viewpoint of suppressing an increase in a driving voltage of the organic light-emitting diode 1, it is preferable that the thickness thereof, for example, is 0.5 nm to 10 nm, and it is preferable that the thickness is 2 nm to 7 nm, from the viewpoint of electron injection properties.

The organic light-emitting diode 1 may include a single organic functional layer 7, or may include two or more organic functional layers 7. In any one of the layer configurations of (a) to (i) described above, in a case where a laminated structure disposed between the anode layer 5 and the cathode layer 9 is set to "Structure Unit A", examples of the configuration of an organic light-emitting diode including two organic functional layers 7 are capable of including a layer configuration represented in (j) described below. Layer configurations of two (Structure Units A) may be identical to each other, or may be different from each other.
(j) Anode Layer/(Structure Unit A)/Charge Generating Layer/(Structure Unit A)/Cathode Layer

Here, the charge generating layer is a layer that generates holes and electrons by applying an electric field. Examples of the charge generating layer are capable of including a thin film formed of vanadium oxide, ITO, molybdenum oxide, or the like.

In a case where "(Structure Unit A)/Charge Generating Layer" is set to "Structure Unit B", examples of the configuration of an organic light-emitting diode including three or more organic functional layers 7 are capable of including a layer configuration represented in (k) described below.
(k) Anode Layer/(Structure Unit B)x/(Structure Unit A)/Cathode Layer

A symbol "x" indicates an integer of greater than or equal to 2, and "(Structure Unit B)x" indicates a laminated body in which (Structure Unit B) is laminated in x stages. Layer Configurations of a plurality of (Structure Units B) may be identical to each other, or may be different from each other.

The organic light-emitting diode may be configured by directly laminating a plurality of organic functional layers 7 without providing the charge generating layer.

In the embodiment described above, a mode of forming the anode layer 5 on the support substrate 3 has been described as an example. However, a roll may be used in which the anode layer 5 is formed in advance on the support substrate 3.

In the embodiment described above, in the method for manufacturing the organic light-emitting diode 1, a mode of performing a step of heating and drying the support substrate 3 has been described as an example. However, the drying step of the support substrate 3 may not be necessarily performed.

In the embodiment described above, a mode of using the cutting unit 50 in the cutting step S06 has been described as an example. However, the cutting blade used in the cutting step S06 may not be provided with the elastic members 54 and 55. That is, the cutting blade may be used alone.

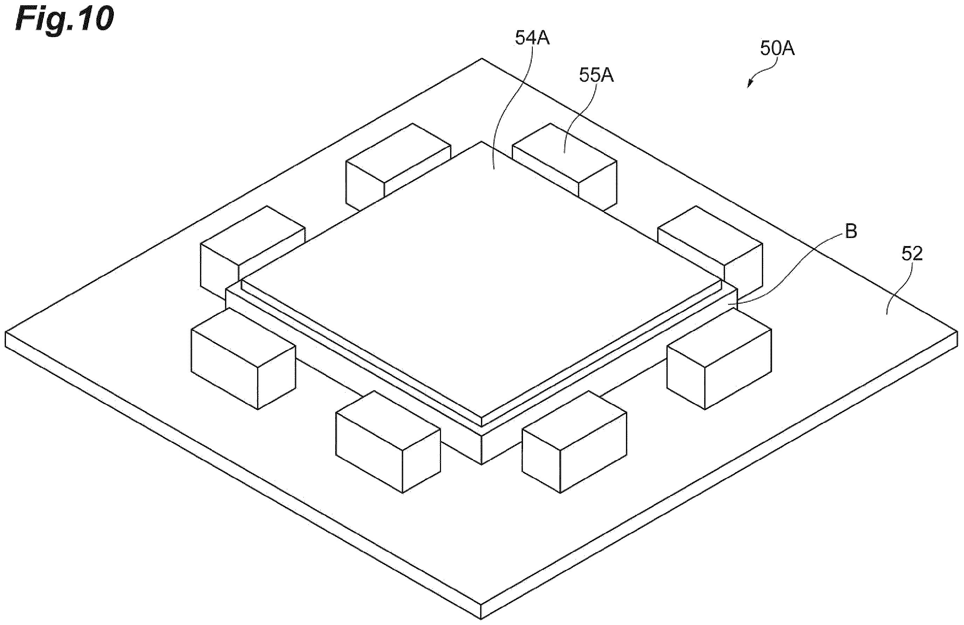

In the embodiment described above, a mode of using the cutting unit 50 illustrated in FIG. 7 has been described as an example. However, the cutting unit may have a configuration illustrated in FIG. 10. As illustrated in FIG. 10, a cutting unit 50A includes the cutting blade B, the retaining portion 52, and elastic members 54A and 55A. The cutting unit 50A is different from the cutting unit 50 in the configuration of the elastic members 54A and 55A. The elastic members 54A and 55A are disposed to face each other in a position in which the cutting blade B is interposed between the elastic members. The elastic member 54A is positioned outside the cutting blade B, and a plurality of (here, eight) elastic members 54A are provided at predetermined intervals. The elastic member 55A is disposed inside the cutting blade B that is in the shape of a frame, and has a shape according to the cutting blade B (a rectangular shape). As illustrated in FIG. 10, a tip end portion of the elastic members 54A and 55A (an end portion on a side opposite to an end portion that is joined to the retaining portion 52) is protrudes from a tip end of the cutting blade B.

In the embodiment described above, a mode in which the elastic members 54 and 55 (54A and 55A) are disposed to face each other as a pair in a position in which the cutting blade B is interposed between the elastic members has been described as an example. However, the elastic member may be disposed on one blade surface side. For example, as illustrated in FIG. 7 or FIG. 10, in a case where the cutting blade B is in the shape of a frame, the elastic member may be only the elastic member 54 disposed inside the frame or the elastic member 54A, from the viewpoint of enabling the film to be discharged from the frame at the time of the cutting.

In the embodiment described above, as illustrated in FIG. 4, a mode of forming the plurality of organic EL units 10 in the longitudinal direction of the support substrate 3 (the Y direction of FIG. 4), at predetermined intervals and of forming the plurality of organic EL units 10 in the width direction of the support substrate 3 (the X direction of FIG. 4), at predetermined intervals, on the support substrate 3, has been described as an example. That is, a mode of forming two rows (a plurality of rows) of organic EL units 10 on the support substrate 3 has been described as an example. However, at least one row of organic EL units 10 may be formed on the support substrate 3.

In the embodiment described above, a mode of using the single-edge blade type cutting blade B in the cutting of the sealing member 11, and of allowing the adhesive portion 17 to protrude to the outside from the sealing base material 19 has been described as an example. However, a method for allowing the adhesive portion 17 to protrude is not limited thereto.

In the embodiment described above, the anode layer has been exemplified as the first electrode layer, and the cathode layer has been exemplified as the second electrode layer, but the first electrode layer may be the cathode layer, and the second electrode layer may be the anode layer. That is, the cathode layer may be disposed on the support substrate side.

In the embodiment described above, the organic light-emitting diode has been described as an example of the organic device. The organic device may be an organic thin film transistor, an organic detector, an organic thin film solar cell, and the like.

### Examples

Hereinafter, the present invention will be described in more detail, on the basis of examples, but the present invention is not limited thereto.

### [Example 1]

A PET film having a thickness of 38 µm was bonded to an aluminum foil having a thickness of 30 µm (JIS 1N30: Hard), and then, an olefin-based pressure-sensitive adhesive was applied onto an exposed surface of the aluminum foil to have a thickness of 30 µm. The aluminum foil coated with the adhesive was affixed onto a sputtering film forming surface of a PEN film having a thickness of 100 µm on which a copper sputtering film was formed, and thus, a laminated body was obtained in which the PET film, the aluminum foil, the pressure-sensitive adhesive, the copper sputtering film, and the PEN film were laminated. In the laminated body, the PET film and the aluminum foil correspond to the sealing base material 19, the copper sputtering film corresponds to the cathode layer 9, and the PEN film corresponds to the support substrate 3.

The cutting blade had a single-edge blade structure, and was machined by a NC processing machine such that a blade height was 1.3 mm, and a vertex angle (an angle between the first blade surface Ba and the second blade surface Bb) was 30°, and the surface was coated by nickel plating. The cutting blade was disposed in the retaining portion 52 such that one blade surface (the second blade surface Bb) was perpendicular to the retaining portion 52 (refer to FIG. 10), that is, such that θ1 = 30° and θ2 = 0° were obtained. A material that pressurized the surface of the film at a pressure of approximately 1.3 kg/cm² when the retaining portion 52 was closest to the PET film at the time of cutting the laminated body was selected as the elastic members 54A and 55A (refer to FIG. 10).

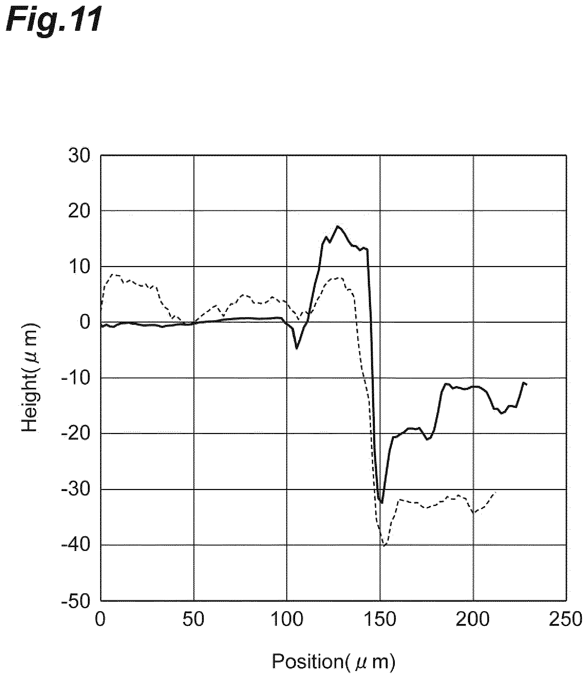

The laminated body was cut by the cutting blade. Specifically, the cutting blade advanced in the order of the PET film, the aluminum foil, the pressure-sensitive adhesive, and the PEN film, and thus, the laminated body was cut. A sectional surface of the laminated body was measured with a double scan high-accuracy laser measurement device (Product Name: LT-9000, manufactured by KEYENCE CORPORATION). A sectional surface of one blade surface side described above was measured as the sectional surface of the laminated body. A measurement result is illustrated in FIG. 11. In FIG. 11, the abscissa represents a position [µm], and the ordinate represents a height [µm]. In the abscissa, "0" is one surface position of the PEN film to which the pressure-sensitive adhesive is not affixed. In FIG. 11, a solid line represents a measurement result of a single-edge blade (θ1 = 30° and θ2 = 0°), and a broken line represents a measurement result of a double-edge blade (θ1 = 15° and θ2 = 15°).

As illustrated in FIG. 11, in a case where the single-edge blade was used as the cutting blade, the pressure-sensitive adhesive protruded approximately 20 µm with respect to a sectional surface of the PEN film after the laminated body was cut. In a case where the double-edge blade was used as the cutting blade, a protruding amount of the pressure-sensitive adhesive was small compared to a case of the single-edge blade. Therefore, it was found that the laminated body is cut by using the single-edge blade as the cutting blade, and thus, it was possible to more reliably allow the pressure-sensitive adhesive to protrude to the outside from the PEN film.

### [Example 2]

As with Example 1, a laminated body was obtained in which a PET film, an aluminum foil, a pressure-sensitive adhesive, and a PEN film were laminated.

The cutting blade had a single-edge blade structure, and was machined by an NC processing machine such that a blade height was 1.3 mm, and a vertex angle (an angle between the first blade surface Ba and the second blade surface Bb) was 40°, and the surface was coated by nickel plating. The cutting blade was disposed in the retaining portion 52 such that one blade surface (the second blade surface Bb) was perpendicular to the retaining portion 52 (refer to FIG. 10), that is, such that θ1 = 40° and θ2 = 0° were obtained. A material that pressurized the surface of the film at a pressure of approximately 1.3 kg/cm² when the retaining portion 52 was closest to the PET film at the time of cutting the laminated body was selected as the elastic members 54A and 55A (refer to FIG. 10).

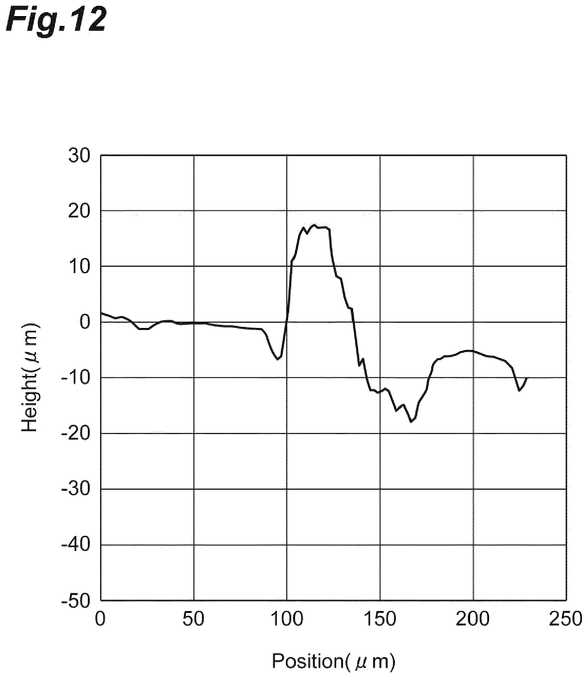

The laminated body was cut in the same condition as that of Example 1. A sectional surface of the laminated body was measured with a double scan high-accuracy laser measurement device (Product Name: LT-9000, manufactured by KEYENCE CORPORATION). A sectional surface of one blade surface side described above was measured as the sectional surface of the laminated body. A measurement result is illustrated in FIG. 12. In FIG. 12, the abscissa represents a position [µm], and the ordinate represents a height [µm]. In the abscissa, "0" is one surface position of the PEN film to which the pressure-sensitive adhesive is not affixed.

As illustrated in FIG. 12, the pressure-sensitive adhesive protruded approximately 20 µm with respect to a sectional surface of the PEN film after the laminated body was cut.

### Reference Signs List

1: organic light-emitting diode (organic device), 3: support substrate, 3a: one main surface, 5: anode layer (first electrode layer), 7: organic functional layer, 9: cathode layer (second electrode layer), 11: sealing member, 17: adhesive portion, 19: sealing base material, B: cutting blade, Ba: first blade surface, Bb: second blade surface.

## Claims

1. A method for manufacturing an organic device, comprising:
a forming step of forming a plurality of organic device units in which at least a first electrode layer, an organic functional layer, and a second electrode layer are laminated in this order, on one main surface of a support substrate extending in one direction, at predetermined intervals in the one direction;
an affixing step of affixing a sealing member extending in the one direction along the one direction such that a part of each of the first electrode layer and the second electrode layer in each of the organic device units is exposed and the sealing member straddles across the plurality of organic device units; and
a cutting step of dividing the plurality of organic device units to which the sealing member is affixed,
wherein in the affixing step, the sealing member including a sealing base material containing a material having conductivity, and an adhesive portion containing a pressure-sensitive adhesive is affixed to the organic device unit, and
in the cutting step, a cutting blade is allowed to approach from the sealing member side, and the sealing member is cut such that the adhesive portion after being cut protrudes to the outside from the sealing base material.

2. The method for manufacturing an organic device according to claim 1,
wherein in the cutting step, the cutting blade having a single-edge blade structure is used, a surface of the cutting blade having a smaller inclination angle with respect to an approach direction of the cutting blade is positioned on the organic device unit side, and the cutting blade is allowed to approach the sealing member.

3. An organic device, comprising:
an organic device unit in which at least a first electrode layer, an organic functional layer, and a second electrode layer are laminated in this order, on a support substrate; and
a sealing member disposed on the organic device unit such that a part of each of the first electrode layer and the second electrode layer in the organic device unit is exposed,
wherein the sealing member is configured by laminating at least a sealing base material containing a material having conductivity, and an adhesive portion containing a pressure-sensitive adhesive, and
the adhesive portion protrudes to the outside from the sealing base material.
